# EUROPEAN PATENT SPECIFICATION

(11) **EP 0 523 421 B1**
(45) Date of publication and mention of the grant of the patent: **19.03.1997**
(21) Application number: 92110773.6
(22) Date of filing: 26.06.1992
(51) Int. Cl.: H05K 1/00, C08K 5/03

(54) **Boards for high frequency circuits**
Platinen für Hochfrequenzschaltungen
Platines pour circuits à haute fréquence

(30) Priority: 12.07.1991 JP 171552/91
(43) Date of publication of application: 20.01.1993
(73) Proprietor: HITACHI CHEMICAL CO., LTD., Shinjuku-ku, Tokyo (JP)
(72) Inventor: Tazaki, Satoshi, Kawasaki-shi, Kanagawa-ken (JP); Sugawara, Takao, Shimodate-shi, Ibaraki-ken (JP); Yamaguchi, Yutaka, Yuki-shi, Ibaraki-ken (JP)
(74) Representative: Strehl Schübel-Hopf Groening & Partner

(56) References cited:
- EP-A- 0 297 888
- EP-A- 0 400 935
- US-A- 4 211 687
- US-A- 4 311 749
- CHEMICAL ABSTRACTS, vol. 112, no. 15, April 09, 1990 Columbus, Ohio, USA MINORU TAKAISHI et al. "Flame-retarded laminate board for electric circuit.", page 831, column 2, abstract-no. 130 796f
- CHEMICAL ABSTRACTS, vol. 110, no. 14, April 03, 1989 Columbus, Ohio, USA NORITAKA OYAMA et al. "Manu- facture of copper-clad laminates containing treated fibers for circuit boards.", page 63, column 1, abstract-no. 116 218w
- CHEMICAL ABSTRACTS, vol. 113, no. 14, October 01, 1990 Columbus, Ohio, USA JINICHI NINAGAWA et al. "Fire-resistant ethylenic co- polymer resin compositions for printed electric circuits.", page 57, column 1, abstract-no. 116 608k
- CHEMICAL ABSTRACTS, vol. 113, no. 22, November 26, 1990 Columbus, Ohio, USA TOSHIYUKI ARAI et al. "Glass fiber prepreg laminates for high-frequency circuit boards.", page 64, column 2, abstract-no. 192 804m
- CHEMICAL ABSTRACTS, vol. 114, no. 14, April 08, 1991 Columbus, Ohio, USA SATOSHI TAZAKI et al. "Boards for high-frequency electric circuits.", page 793, column 2, abstract-no. 134 115x
- CHEMICAL ABSTRACTS, vol. 115, no. 16, October 21, 1991 Columbus, Ohio, USA SATOSHI TAZAKI et al. "High- -frequency printed circuit board.", page 924, column 2, abstract-no. 172 372g

## Description

### BACKGROUND OF THE INVENTION

### (a) Field of the Invention

The present invention relates to boards for electronic instruments, particularly to boards for high frequency circuits suitable for use with high frequency signals.

### (b) Description of the Related Art

Recently, the frequency of signals used in electronic industries and communication industries has gradually increased to a higher frequency region, and the conventional signals of kHz frequencies have become replaced by signals of high frequencies in the region of MHz or GHz. In such a high frequency region, the velocity and loss of signals affect the efficiency of circuits considerably, and there is a demand for electric parts and laminates which increase the velocity of signals of high frequency region and reduce the loss of the signals. The velocity of a signal in a circuit on a laminate depends on the dielectric constant (ε_{γ} ) of the dielectric material in the laminate, and the lower the ε_{γ} is, the higher is the velocity of the signal. The loss of the signal depends on the ε_{γ} and dielectric loss tangent (tanδ ) of the dielectric material, and the lower the ε_{γ} and tanδ are, the lesser is the loss of the signal. Therefore, the production of boards for high frequency circuits requires use of dielectric materials having low ε_{γ} and low tanδ . As a dielectric material having low ε_{γ} and low tanδ , glass cloth impregnated with resins, such as polytetrafluoroethylene or polyethylene, has been used for the production of conventional boards for high frequency circuits by laminating it with copper foil.

Polytetrafluoroethylene has high melting point and low flowability, and polytetrafluoroethylene/glass cloth boards, which are produced by using dielectric materials prepared by impregnating glass cloth with polytetrafluoroethylene, have a shortcoming of requiring lengthy forming at high temperatures for their production. On the other hand, polyethylene has a low melting point, and polyethylene/glass cloth boards, which are produced by using glass cloth impregnated with polyethylene, have a shortcoming of poor soldering heat resistance.

As a means of dissolving these shortcomings, we proposed in the specifications of Japanese Patent Application Kokai Koho (Laid-open) Nos. 3-109791 and 3-109792 a method of producing a board for high frequency circuits wherein a porous sheet of ultra high molecular weight polyethylene (UHMWPE) was laminated with a resin-impregnated reinforcing layer (prepreg) comprising a reinforcing material impregnated with an uncured curable resin, and the laminate was then heated and pressed to destroy the porosity and to cure the curable resin. This method made it possible to make use of the low ε_{γ} and low tanδ of UHMWPE and to improve the heat resistance of the resulting board by making use of the low flowability of melted UHMWPE, with the problems in molding overcome by laminating the prepreg and the UHMWPE porous sheet.

Further in order to improve the continuity reliability of through holes in boards for high frequency circuits, we proposed in the specification of Japanese Patent Application Kokai Koho (Laid-open) No. 4-44386 a board for high frequency circuits and a method of producing the same. In the method used is a prepreg impregnated with an uncured curable resin having a melt viscosity of 3000 poise or less. The resulting board however did not conduce sufficiently to increase the continuity reliability of through holes. Herein, the melt viscosity of uncured curable resins in prepregs means the lowest viscosity that is obtained by crumpling up and loosening a prepreg without breaking the reinforcing material therein, sieving the resin powder falling off from the prepreg to obtain a sample powder passed through a 100 mesh sieve, and measuring the melting point of the sample powder with a flow tester (SHIMAZU FLOW TESTER CFT-500C produced by Shimazu Seisakusho Co., Ltd.) at 130 °C with a load of 3 kg.

In, for example, Japan Electronic Material Technique Society Bulletin, Vol. 10, 1, "Relating to the Reliability of Through Hole Printed Circuits", 1978, reducing the thermal expansion of boards has been proved effective in improving the continuity reliability of through holes. As disclosed in The Elements of Chemistry No. 8, "Composite Materials", p33-37, (1975, the Society Publishing Center) edited by The Japan Chemical Society, addition of fillers is a general means of reducing the thermal expansion. However, the use of fillers for improving the continuity reliability of through holes involves the problem that the fillers increase ε_{γ} and tanδ. Fillers do not take effect unless they are added in large quantities, and silicon dioxide is the only one that is known to be a filler not causing much increases of ε_{γ} and tanδ. Nevertheless even silicon dioxide involves a problem in that the water absorbed therein increases ε_{γ} and tanδ.

From US-A-4 311 749, there is known a flame proof printed circuit board the flexible resin film of which can be made of polyethylene. Among the flame retardant additives, hexabromobenzene is mentioned.

### SUMMARY OF THE INVENTION

An object of the present invention is to provide a board for high frequency circuits which has low ε_{γ} and low tanδ in spite of the presence of a large quantity of fillers and as well gives an improved continuity reliability to through holes.

In order to solve the above-described problems, we made research on various fillers, and found that halogenated organic compounds having symmetric structure provided boards having low ε_{γ} and low tanδ and being improved in the continuity reliability of through holes. On the basis of this finding, we have completed the present invention.

That is, the present invention provides a board for high frequency circuits with the features defined in claim 1. The board comprises
a resin sheet comprising an ultra high molecular weight polyethylene and a cured curable resin dispersed in the ultra high molecular weight polyethylene;
a reinforcing layer on at least one side of the resin sheet, the reinforcing layer comprising a reinforcing material impregnated with a cured curable resin; and
a metal conductor layer on the reinforcing layer;
wherein a halogenated organic compound having symmetric structure is dispersed in at least one of the resin sheet and the reinforcing layer.

### BRIEF DESCRIPTION OF THE DRAWING

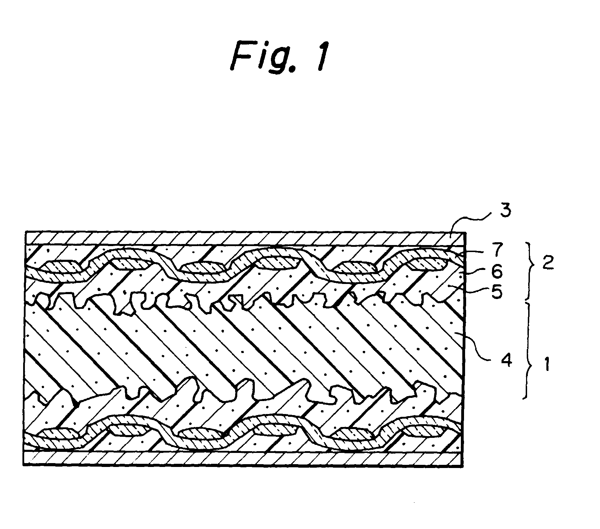

Fig. 1 is a sectional view illustrating the structure of an embodiment of the board for high frequency circuits according to the present invention.

### DESCRIPTION OF THE PREFERRED EMBODIMENT

Hereinafter, the present invention will be described referring to Fig. 1 which is a sectional view illustrating the structure of an embodiment of the board for high frequency circuits according to the present invention. A referential numeral 1 represents a resin sheet, a referential numeral 2 represents a reinforcing layer on each side of the resin sheet 1, and a referential numeral 3 represents a metal conductor layer on each reinforcing layer 2. A referential numeral 4 represents an ultra high molecular weight polyethylene (UHMWPE) wherein a cured curable resin is dispersed, a referential numeral 5 represents a halogenated organic compound having symmetric structure, a referential numeral 6 represents a cured curable resin, and a referential numeral 7 represents a reinforcing material. The resin sheet 1 comprises the UHMWPE 4, the cured curable resin and the halogenated organic compound 5, the cured curable resin and the halogenated organic compound 5 being dispersed in the UHMWPE 4. The reinforcing layers 2 comprises the reinforcing material 7 impregnated with the cured curable resin 6 and the halogenated organic compound 5, the halogenated compound 5 being dispersed in the reinforcing layers 2.

In the board for high frequency circuits of the present invention, the resin sheet is preferably 0.05 to 5 mm thick, more preferably 0.08 to 3 mm thick, the reinforcing layer is preferably 30 to 200 µm thick.

The halogenated organic compound may be dispersed both in the resin sheet and in the reinforcing layer as shown in Fig. 1, and it may also be dispersed only in the resin sheet or only in the reinforcing layer. When the halogenated organic compound is dispersed in only one of the resin sheet or the reinforcing layer, it is dispersed preferably in the resin sheet which can contain a large quantity of the halogenated organic compound, thereby increasing the percentage of the halogenated organic compound in the board.

The board for high frequency circuits of the present invention may be produced by, for example, laminating a reinforcing sheet (prepreg) comprising a reinforcing material impregnated with an uncured curable resin on one or both sides of a UHMWPE porous sheet and then heating and pressing the laminate, thereby destroying the porosity of the UHMWPE porous sheet and, simultaneously, pressing the uncured curable resin contained in the prepreg into the pores of the UHMWPE porous sheet and curing the curable resin. The halogenated organic compound may be dispersed in the resin sheet or in the reinforcing layer by adding the halogenated organic compound at the time of producing the prepreg or the UHMWPE porous sheet.

The halogenated organic compound having symmetric structure to be used in the present invention is selected from the brominated organic compounds decabromodiphenyl ether and hexabromobenzene and from the chlorinated organic compound 1,2,3,4,7,8,9,10,13,13,14,14-dodecachloro-1,4,4a,5,6,6a,7,10,10a,11,12,12a-dodecahydro-1,4:7,10-dimethanodibenzo(a,e)cyclooctene (Trade name: Dechloran Plus produced by Occidental Chemical Co., Ltd.) having the following structure, and mixtures of these compounds. A preferred halogenated organic compound is Dechloran Plus which does not generate poisonous matters, such as dioxin and furan.

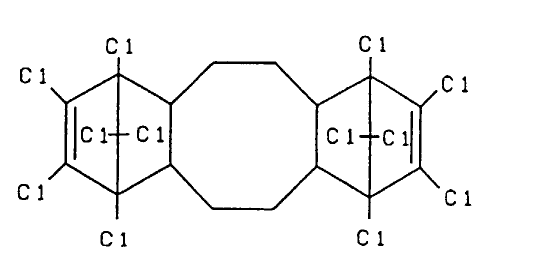

Dechloran Plus is known (see e.g. US-A-4 211 687) as a flame-retarding agent but is not known to increase substantially the continuity reliability of through holes without increasing ε_{γ} and tanδ in spite of addition thereof in such a large quantity as in the present invention.

The quantity of the halogenated organic compound used in the present invention is 30 to 180 parts by weight, preferably 50 to 120 parts by weight per 100 parts by weight of UHMWPE. If the quantity of the halogenated organic compound is less than 30 parts by weight, the halogenated organic compound may be of no effect on improving the continuity reliability of through holes. If it exceeds 180 parts by weight, mixing may become very difficult, resulting in separation of the halogenated organic compound.

The halogenated organic compound preferably has a mean particle size of 0.01 to 200 µm.

The UHMWPE to be used as a material of the UHMWPE porous sheet is produced by Ziegler process and has a viscosity-average molecular weight of 1,000,000 to 5,000,000, which is considerably larger than the viscosity-average molecular weights, 20,000 to 200,000, of common polyethylenes. Preferred examples includes the commercially available ones, such as HIZEXMILLION, MIPERON (Trade names, produced by Mitsui Petrochemical Industries, Ltd.), SANTEC (Trade name, produced by Asahi Chemical Industry Co., Ltd.), HOSTALEN. GUR (Trade name, produced by Hoechst AG), and HIFLAX. 1000 (Trade name, produced by Hercules Inc.).

The UHMWPE porous sheet is produced by sintering powdery particles of UHMWPE to stick the particles together by fusion and to form a porous sheet of 0.1 to 5 mm thick. The porous sheet contains a continuous layer of the air surrounding the stuck particles.

For example, the UHMWPE porous sheet is produced continuously by placing a mixture of the powdery particles of UHMWPE and the halogenated organic compound on a sheet, such as a film or a metal belt, moving the sheet under rolls or bars with the distance between the rolls or bars and the sheet maintained constant to form a layer of the mixture having a constant thickness, and then passing the sheet through a heating furnace to heat and sinter the powdery particles of UHMWPE for formation of a UHMWPE porous sheet. The sintering is preferably carried out at a temperature of 140 to 200 °C for 5 to 120 minutes. The UHMWPE porous sheet preferably has an apparent density of 0.5 to 1.0 g/cm³. At the time of the production, the powdery particles of UHMWPE may be coated with adhesives or mixed with adhesive particles or with stabilizers, flame-retarding agents or colorants.

The powdery particles of UHMWPE preferably have an mean particle size of 0.001 to 1 mm. Those having a mean particle size of 0.001 to 0.1 mm are particularly suitable for the production of UHMWPE porous sheets having smooth surfaces.

Some examples of the prepreg include the ones conventionally used in boards for printed circuits, that are produced by impregnating a reinforcing material, such as glass cloth, glass non-woven cloth or woven or non-woven cloth of plastic fiber, with varnish of a curable resin, followed by drying. Some examples of the curable resin for impregnation include unsaturated polyester resin, epoxy resin, phenolic resin, melamine resin, diallylphthalate resin, polyimide resin, bis-maleimide·triazine resin, a resin composition comprising polyphenyleneoxide (PPO) and a crosslinkable polymer or a crosslinkable monomer, and a resin composition comprising polyphenylenesulfide (PPS) and a crosslinkable polymer or a crosslinkable monomer. Preferred are polyester, epoxy resin and polyimide, which have relatively low ε_{γ} and tanδ . From the viewpoint of cost, epoxy resin is particularly preferable. The quantity of the prepreg used is preferably 50 to 200 g/m², and the prepreg preferably contains 20 to 80 % by weight of the curable resin.

The reinforcing layer may be produced by impregnating a reinforcing material with a resin in the state of a dispersion or solution and then drying the dispersive medium or solvent used, or by impregnating the reinforcing material with a resin with pressure. The former is suitable since it is effective in avoiding air bubbles' remaining.

Some examples of the metal conductor layer to be laminated on the reinforcing layer include foil or plate of copper, copper alloys, such as cupro-nickel, bronze and brass, aluminum, nickel, iron, iron alloys, such as stainless steel, gold, silver and platinum. Preferred examples are copper foil, aluminum foil, aluminum plate and iron alloy plate. Other than these metal foil and plate, the metal conductor layer may be a copper-plated or silver-plated layer which is formed into a desired circuit. The thickness of the metal conductor layer is generally 10 to 50 µm.

The heating and pressing for the production of the board of the present invention is generally carried out at 130 to 250 °C with an applied pressure of 20 to 80 kgf/cm² (0.2 to 7.8 MPa), for 20 to 120 minutes. It is preferable to carry out the heating and pressing under a uniform condition by sandwiching the UHMWPE porous sheet, prepreg and metal conductor layer between two end plates.

Since the molecules of the halogenated organic compound used as a filler in the present invention have symmetric structure, they have low polarity and have low ε_{γ} and low tanδ . In particular, Dechloran Plus did not cause much increases in ε_{γ} and tanδ even if it was used in a large quantity, and is particularly effective. Further, the halogenated organic compound reduces thermal expansion of the board, and as well improves the adhesion of through hole plate, thereby providing through holes with good continuity reliability.

Hereinafter, the present invention will be described in detail referring to Examples, but the Examples do not limit the scope of the present invention.

### EXAMPLES 1 TO 6 AND COMPARATIVE EXAMPLES 1 TO 4

### EXAMPLES 1 TO 6

In each Example, 100 parts by weight of MIPERON XM220 (Trade name, viscosity-average molecular weight: 1-5 × 10⁶, mean particle size: 0.03 mm, melting point: 136 °C , bulk density: 0.4 g/cm³, true density: 0.94 g/cm³, produced by Mitsui Petrochemical Industry, Ltd.) as a high molecular weight polyethylene was mixed with Dechloran Plus 25 (Trade name, chlorine content: 65 % by weight, mean particle size: 0.003 mm, bulk density: 0.67 g/cm³, true density: 1.9 g/cm³, produced by Occidental Chemical Co., Ltd.) as a filler in the quantity listed in Table 1 by using a mixer. The mixture was placed on a stainless steel belt to a thickness of 1.3 mm, and was then heated for sintering in a heating furnace of 180 °C for 15 minutes, to obtain a UHMWPE porous sheet containing the filler and having an apparent density of 0.55 g/cm³.

On each side of each porous sheet laminated were a 133 g/cm² of prepreg comprising glass cloth of 50 µm thick impregnated with chlorinated bisphenol-A epoxy resin (Tg: 130 °C ) (resin content: 60 % by weight) and an electrolytic copper foil of 35 µm thick, in that order, and the laminate was then heated and pressed by using two end plates of stainless steel at a temperature of 175 °C and at a pressure of 20 kgf/cm² for 90 minutes, to produce a board for high frequency circuits of 0.9 mm thick (resin sheet layer: about 0.71 mm, reinforcing layer: about 0.06 mm).

### COMPARATIVE EXAMPLE 1

A board for high frequency circuits of 0.8 mm thick was produced in the same manner as in Example 1 with the exception that no filler was used.

### COMPARATIVE EXAMPLE 2

A board for high frequency circuits of 0.8 mm thick was produced in the same manner as in Example 1 with the exception that calcium carbonate NS#100 (Trade name, mean particle size: 0.00212 mm, bulk density: 0.46 g/cm³, true density: 2.7 g/cm³, produced by Nitto Funka Kogyo Kabushiki Kaisha) was used as a filler in a quantity of 142 parts by weight so as to make the same volume ratio as that of Example 3.

### COMPARATIVE EXAMPLE 3

A board for high frequency circuits of 0.8 mm thick was produced in the same manner as in Example 1 with the exception that silicon dioxide Aerosil 200 (Trade name, mean particle size: 12 mµ , produced by Nippon Aerosil Kabushiki Kaisha) was used as a filler in a quantity of 110 parts by weight so as to make the same volume ratio as that of Example 3.

### COMPARATIVE EXAMPLE 4

A board for high frequency circuits of 0.8 mm thick was produced by laminating four sheets of prepregs (resin content: 50 % by weight), each comprising glass cloth of 200 µm thick impregnated with the same epoxy resin as that used in Examples, laminating the same copper foil as that used in Examples on each side of the laminate, and then carrying out heating and pressing in the same manner as in Examples.

Each of the boards for high frequency circuits obtained in Examples 1 to 6 and Comparative Examples 1 to 4 was drilled to conform to the standard test pattern of JIS C 5012. After plated with copper to a thickness of 0.5 µm by using an electroless copper plating liquid CUST (Trade name, produced by Hitachi Chemical Company, Ltd.), the drilled board was further plated with copper to a thickness of 30 µm by an electroplating with copper sulfate, to obtain a sample with plated through holes. A thermal shock test was made on the sample by repeating cycles of dipping in an oil of 260 °C for 10 seconds and dipping in water of room temperature for 10 seconds. The results of the thermal shock test made on the boards of Examples 1 to 6 are listed in Table 1, and those of the boards of Example 3 and Comparative Examples 1 to 4 are listed in Table 2.

The copper foils on the boards produced in Example 3 and Comparative Examples 1 to 4 were removed of by etching, and the thermal expansions (the changes in thickness per unit thickness) of the boards in the direction of thickness caused by an increase of temperature from room temperature to 260 °C were measured by using a thermal mechanical analyzer TMA-8140 (produced by Rigaku Denki Kabushiki Kaisha). Measurements of ε_{γ} and tanδ were made by a 12 GHz cavity resonator process.

The porous sheets produced in Example 3 and Comparative Examples 1 to 3 were heated and pressed at 200 °C and at a pressure of 60 kgf/cm² for 10 minutes, to form resin sheets having no cavities. The epoxy resin used in Comparative Example 4 was heated and pressure at 175 °C at a pressure of 20 kgf/cm² for 90 minutes in the absence of the reinforcing material used in Comparative Example 4, to form a resin sheet. These resin sheets were plated in the same manner as in the above Examples, and measurements of peel strength were carried out. The results are shown in Table 2.

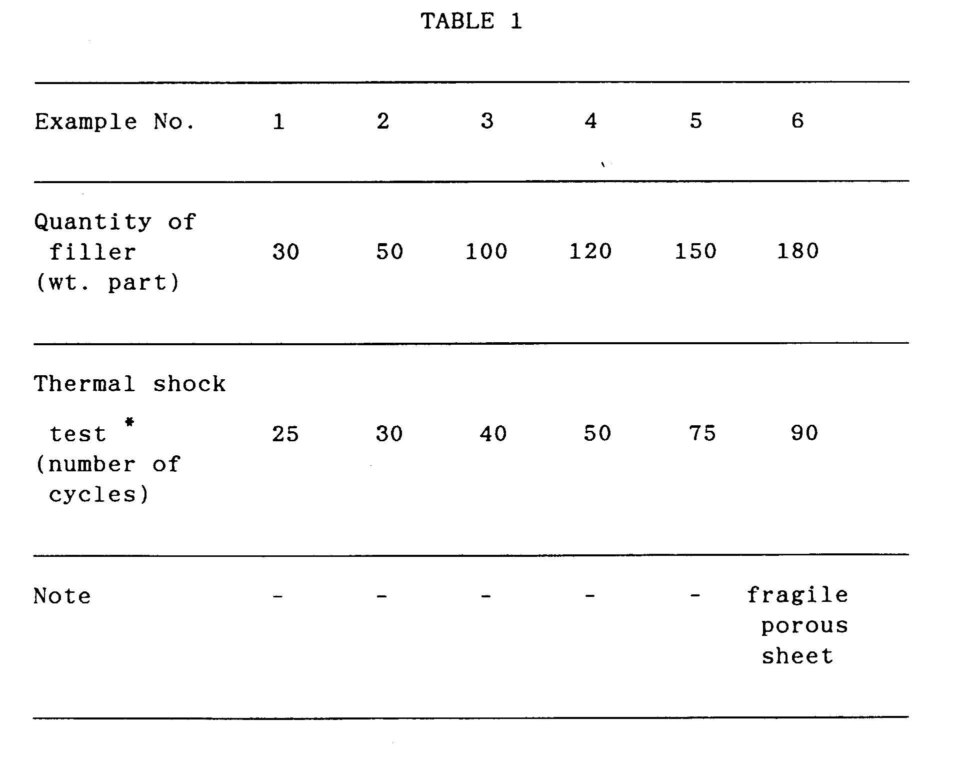

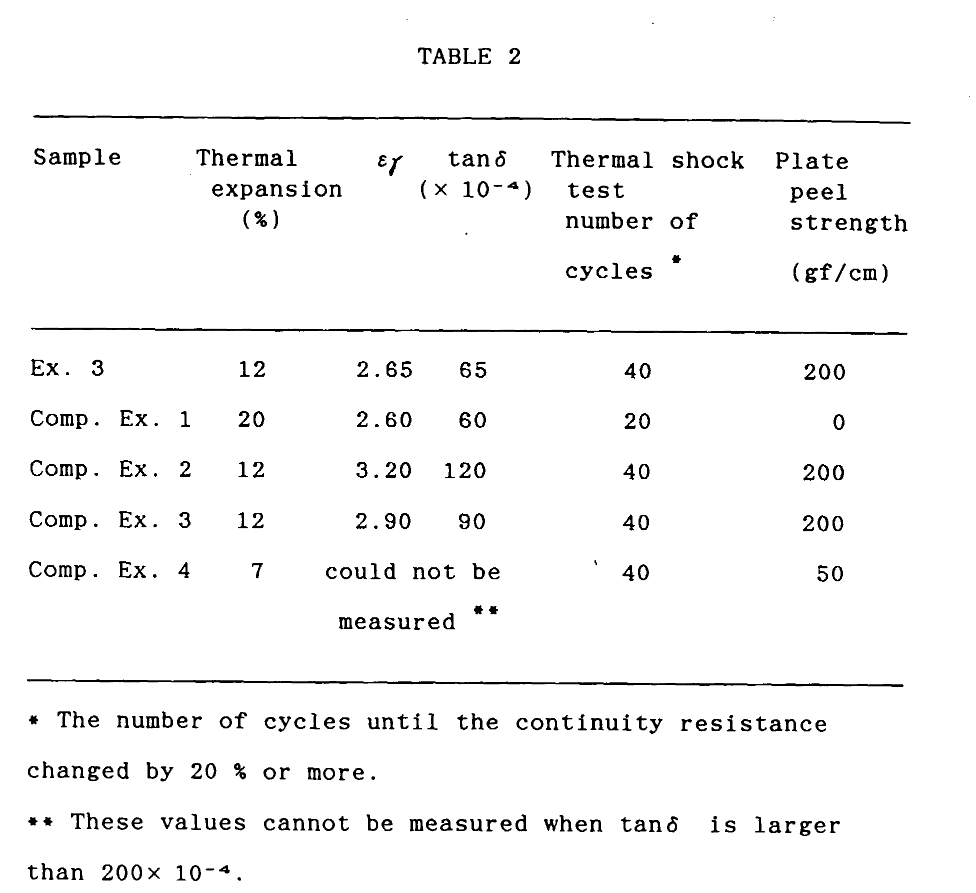

Comparing Example 3 with Comparative Example 1 shows that even slight increases in ε_{γ} and tanδ doubled the number of cycles in the thermal expansion test. In Comparative Examples 2 and 3, ε_{γ} and tanδ increased considerably.

In Comparative Example 4 wherein the board for high frequency circuits was produced by using only the copper foil, glass cloth and epoxy resin, the number of cycles in the thermal expansion test was the same as that of Example 3 in spite of its smaller thermal expansion than that of Example 3, because it had low plate peel strength. It is therefore conceivable that the halogenated organic compound used as a filler in the present invention has the effect of improving the adhesion of copper-plating.

According to the present invention, the halogenated organic compound dispersed in the board for high frequency circuits reduces the thermal expansion of the board and improves the adhesion of copper-plating, thereby improving the continuity reliability in through holes. Further the symmetric structure of the halogenated organic compound reduces the increases in ε_{γ} and tanδ of the board. Thus the present invention provides a board for high frequency circuits having excellent properties.

## Claims

1. A board for high frequency circuits, comprising:
a resin sheet (1) comprising an ultra high molecular weight polyethylene (4) having a viscosity-average molecular weight of 1,000,000 to 5,000,000 and a cured curable resin dispersed in the ultra high molecular weight polyethylene;
a reinforcing layer (3) on at least one side of the resin sheet, the reinforcing layer comprising a reinforcing material (7) impregnated with a cured curable resin (6); and
a metal conductor layer (3) on the reinforcing layer;
wherein a halogenated organic compound (5) selected from the group consisting of decabromodiphenyl ether, hexabromobenzene, 1,2,3,4,7,8,9,10,13,13,14,14-dodecachloro-1,4,4a,5,6,6a,7,10,10a,11,12,12a-dodecahydro-1,4:7,10-dimethanodibenzo(a,e)cyclooctene and a mixture thereof is dispersed in at least one of the resin sheet and the reinforcing layer in a quantity of 30 to 180 parts by weight per 100 parts by weight of the ultra high molecular weight polyethylene.

2. The board for high frequency circuits as claimed in claim 1, wherein the halogenated organic compound is 1,2,3,4,7,8,9,10,13,13,14,14-dodecachloro-1,4,4a,5,6,6a,7,10,10a,11,12,12a-dodecahydro-1,4:7,10-dimethanodibenzo(a,e)cyclooctene.

3. The board for high frequency circuits as claimed in claim 1, wherein the cured curable resin contained in the resin sheet is a cured product of a curable resin selected from the group consisting of unsaturated polyester resin, epoxy resin, phenolic resin, melamine resin, diallylphthalate resin, polyimide resin, bis-maleimide·triazine resin, a resin composition comprising polyphenyleneoxide and a crosslinkable polymer, a resin composition comprising polyphenyleneoxide and a crosslinkable monomer, a resin composition comprising polyphenylenesulfide and a crosslinkable polymer, and a resin composition comprising polyphenylenesulfide and a crosslinkable monomer.

4. The board for high frequency circuits as claimed in claim 3, wherein the curable resin is selected from the group consisting of unsaturated polyester resin, epoxy resin and polyimide resin.

5. The board for high frequency circuits as claimed in claim 1, wherein the reinforcing material is selected from the group consisting of glass cloth, glass non-woven cloth, non-woven cloth of plastic fiber, woven cloth of plastic fiber and a mixture thereof, and the cured curable resin contained in the reinforcing layer is a cured product of a curable resin selected from the group consisting of unsaturated polyester resin, epoxy resin, phenolic resin, melamine resin, diallylphthalate resin, polyimide resin, bis bis-maleimide·triazine resin, a resin composition comprising polyphenyleneoxide and a crosslinkable polymer, a resin composition comprising polyphenyleneoxide and a crosslinkable monomer, a resin composition comprising polyphenylenesulfide and a crosslinkable polymer, and a resin composition comprising polyphenylenesulfide and a crosslinkable monomer.

6. The board for high frequency circuits as claimed in claim 5, wherein the curable resin is selected from the group consisting of unsaturated polyester resin, epoxy resin and polyimide resin.

7. The board for high frequency circuits as claimed in claim 1, wherein the metal conductor layer is a layer of a metal selected from the group consisting of copper, cupro-nickel, bronze, brass, aluminum, nickel, iron, stainless steel, gold, silver and platinum.

8. The board for high frequency circuits as claimed in claim 1, wherein the reinforcing material is selected from the group consisting of glass cloth, glass non-woven cloth, non-woven cloth of plastic fiber, woven cloth of plastic fiber and a mixture thereof, the metal conductor layer is a layer of a metal selected from the group consisting of copper, cupro-nickel, bronze, brass, aluminum, nickel, iron, stainless steel, gold, silver and platinum, and the cured curable resin contained in the resin sheet is the same resin as the cured curable resin contained in the reinforcing layer and is a cured product of a curable resin selected from the group consisting of unsaturated polyester resin, epoxy resin, phenolic resin, melamine resin, diallylphthalate resin, polyimide resin, bis-maleimide·triazine resin, a resin composition comprising polyphenyleneoxide and a crosslinkable polymer, a resin composition comprising polyphenyleneoxide and a crosslinkable monomer, a resin composition comprising polyphenylenesulfide and a crosslinkable polymer, and a resin composition comprising polyphenylenesulfide and a crosslinkable monomer.

9. The The board for high frequency circuits as claimed in claim 8, wherein the curable resin is selected from the group consisting of unsaturated polyester resin, epoxy resin and polyimide resin.

10. The board for high frequency circuits as claimed in claim 9, wherein the halogenated organic compound is dispersed in the resin sheet.

11. The board for high frequency circuits as claimed in claim 10, wherein the curable resin is epoxy resin, the reinforcing material is glass cloth, the metal conductor layer is a layer of copper, and the halogenated organic compound is 1,2,3,4,7,8,9,10,13,13,14,14-dodecachloro-1,4,4a,5,6,6a,7,10,10a,11,12,12a-dodecahydro-1,4:7,10-dimethanodibenzo(a,e)cyclooctene.

## Patentansprüche

1. Platte für Hochfrequenzschaltungen, welche umfaßt:
eine Harzfolie bzw. -platte (1), enthaltend ein ultrahochmolekulares Polyethylen (4) mit einem Viskositätsmittel des Molekulargewichts von 1.000.000 bis 5.000.000 und ein gehärtetes härtbares Harz, welches in dem ultrahochmolekularen Polyethylen dispergiert ist; eine Verstärkungsschicht (3) auf mindestens einer Seite der Harzfolie, wobei die Verstärkungsschicht ein Verstärkungsmaterial (7) umfaßt, welches mit einem gehärteten härtbaren Harz (6) imprägniert ist; und eine Metalleiterschicht (3) auf der Verstärkungsschicht; wobei eine halogenierte organische Verbindung (5), die aus der aus Decabromdiphenylether, Hexabrombenzol, 1,2,3,4,7,8,9,10,13,13,14,14-Dodecachlor-1,4,4a,5,6,6a,7,10,10a,11,12,12a-dodecahydro-1,4:7,10-dimethandibenzo(a,e)cycloocten und einem Gemisch davon bestehenden Gruppe ausgewählt ist, in der Harzfolie und/oder der Verstärkungsschicht in einer Menge von 30 bis 180 Gewichtsteilen pro 100 Gewichtsteile des ultrahochmolekularen Polyethylens dispergiert ist.

2. Platte für Hochfrequenzschaltungen gemäß Anspruch 1, worin die halogenierte organische Verbindung 1,2,3,4,7,8,9,10,13,13,14,14-Dodecachlor-1,4,4a,5,6,6a,7,10,10a,11,12,12a-dodecahydro-1,4:7,10-dimethandibenzo(a,e)cycloocten ist.

3. Platte für Hochfrequenzschaltungen gemäß Anspruch 1, worin das gehärtete härtbare Harz, welches in der Harzfolie enthalten ist, ein gehärtetes Produkt eines härtbaren Harzes ist, welches aus der aus ungesättigtem Polyesterharz, Epoxyharz, Phenolharz, Melaminharz, Diallylphthalatharz, Polyimidharz, Bismaleimidtriazinharz, einer Harzzusammensetzung, die Polyphenylenoxid und ein vernetzbares Polymeres umfaßt, einer Harzzusammensetzung, die Polyphenylenoxid und ein vernetzbares Monomeres umfaßt, einer Harzzusammensetzung, die Polyphenylensulfid und ein vernetzbares Polymeres umfaßt, und einer Harzzusammensetzung, die Polyphenylensulfid und ein vernetzbares Monomeres umfaßt, bestehenden Gruppe ausgewählt ist.

4. Platte für Hochfrequenzschaltungen gemäß Anspruch 3, worin das härtbare Harz aus der aus ungesättigtem Polyesterharz, Epoxyharz und Polyimidharz bestehenden Gruppe ausgewählt ist.

5. Platte für Hochfrequenzschaltungen gemäß Anspruch 1, worin das Verstärkungsmaterial aus der aus Glasfasergewebe, Glasfaservlies, Vliesstoff aus Kunststoffasern, Glasfasergewebe aus Kunststoffasern und einem Gemisch davon bestehenden Gruppe ausgewählt ist, und das gehärtete härtbare Harz, das in der Verstärkungsschicht enthalten ist, ein gehärtetes Produkt aus einem härtbaren Harz ist, das aus der aus ungesättigtem Polyesterharz, Epoxyharz, Phenolharz, Melaminharz, Diallylphthalatharz, Polyimidharz, Bismaleimidtriazinharz, einer Harzzusammensetzung, die Polyphenylenoxid und ein vernetzbares Polymeres umfaßt, einer Harzzusammensetzung, die Polyphenylenoxid und ein vernetzbares Monomeres umfaßt, einer Harzzusammensetzung, die Polyphenylensulfid und ein vernetzbares Polymeres umfaßt, und einer Harzzusammensetzung, die Polyphenylensulfid und ein vernetzbares Monomeres umfaßt, bestehenden Gruppe ausgewählt ist.

6. Platte für Hochfrequenzschaltungen gemäß Anspruch 5, worin das härtbare Harz aus der aus ungesättigtem Polyesterharz, Epoxyharz und Polyimidharz bestehenden Gruppe ausgewählt ist.

7. Platte für Hochfrequenzschaltungen gemäß Anspruch 1, worin die Metalleiterschicht eine Schicht aus einem Metall, das aus der aus Kupfer, einer Kupfernickellegierung, Bronze, Messing, Aluminium, Nickel, Eisen, rostfreiem Stahl, Gold, Silber und Platin bestehenden Gruppe ausgewählt ist.

8. Platte für Hochfrequenzschaltungen gemäß Anspruch 1, worin das Verstärkungsmaterial aus der aus Glasfasergewebe, Glasfaservlies, Vliesstoff aus Kunststoffasern, Glasfasergewebe aus Kunstoffasern und einem Gemisch davon bestehenden Gruppe ausgewählt ist, die Metalleiterschicht eine Schicht eines Metalls ist, welches aus der aus Kupfer, einer Kupfernickellegierung, Bronze, Messing, Aluminium, Nickel, Eisen, rostfreiem Stahl, Gold, Silber und Platin bestehenden Gruppe ausgewählt ist, und das gehärtete härtbare Harz, das in der Harzfolie enthalten ist, das gleiche Harz wie das gehärtete härtbare Harz, das in der Verstärkungschicht enthalten ist, und ein gehärtetes Produkt eines härtbaren Harzes ist, das aus der aus ungesättigtem Polyesterharz, Epoxyharz, Phenolharz, Melaminharz, Diallylphthalatharz, Polyimidharz, Bismaleimidtriazinharz, einer Harzzusammensetzung, die Polyphenylenoxid und ein vernetzbares Polymeres umfaßt, einer Harzzusammensetzung, die Polyphenylenoxid und ein vernetzbares Monomeres umfaßt, einer Harzzusammensetzung, die Polyphenylensulfid und ein vernetzbares Polymeres umfaßt, und einer Harzzusammensetzung, die Polyphenylensulfid und ein vernetzbares Monomeres umfaßt, bestehenden Gruppe ausgewählt ist.

9. Platte für Hochfrequenzschaltungen gemäß Anspruch 8, worin das härtbare Harz aus der aus ungesättigtem Polyesterharz, Epoxyharz und Polyimidharz bestehenden Gruppe ausgewählt ist.

10. Platte für Hochfrequenzschaltungen gemäß Anspruch 9, worin die halogenierte organische Verbindung in der Harzfolie dispergiert ist.

11. Platte für Hochfrequenzschaltungen gemäß Anspruch 10, worin das härtbare Harz ein Epoxyharz ist, das Verstärkungsmaterial Glasfasergewebe ist, die Metalleiterschicht eine Schicht aus Kupfer ist und die halogenierte organische Verbindung 1,2,3,4,7,8,9,10,13,13,14,14-Dodecachlor-1,4,4a,5,6,6a,7,10,10a,11,12,12a-dodecahydro-1,4:7,10-dimethandibenzo(a,e)cycloocten ist.

## Revendications

1. Carte pour circuits haute fréquence, comprenant :
une feuille de résine (1) comprenant un polyéthylène à très grande masse moléculaire (4), ayant une masse moléculaire moyenne en viscosité de 1 000 000 à 5 000 000, et une résine durcissable durcie en dispersion dans le polyéthylène à très grande masse moléculaire ;
une couche de renforcement (3) sur au moins une face de la feuille de résine, la couche de renforcement comprenant un matériau de renforcement (7) imprégné d'une résine durcissable durcie (6) ; et
une couche conductrice métallique (3) sur la couche de renforcement ;
où un composé organique halogéné (5), choisi dans le groupe comprenant l'oxyde de décabromodiphényle, l'hexabromobenzène, le 1,2,3,4,7,8,9,10,13,13,14,14-dodécachloro-1,4,4a,5,6,6a,7,10,10a,11,12,12a-dodécahydro-1,4:7,10-diméthanodibenzo(a,e)cyclooctène et leurs mélanges, est dispersé dans au moins la feuille de résine ou dans la couche de renforcement, en une quantité de 30 à 180 parties en poids pour 100 parties en poids du polyéthylène à très grande masse moléculaire.

2. Carte pour circuits haute fréquence selon la revendication 1, dans laquelle le composé organique halogéné est le 1,2,3,4,7,8,9,10,13,13,14,14-dodécachloro-1,4,4a,5,6,6a,7,10,10a,11,12,12a-dodécahydro-1,4:7,10-diméthanodibenzo(a,e)cyclooctène.

3. Carte pour circuits haute fréquence selon la revendication 1, dans laquelle la résine durcissable durcie contenue dans la feuille de résine est un produit durci constitué d'une résine durcissable choisie parmi l'ensemble comprenant une résine de polyester, une résine époxyde, une résine phénolique, une résine de mélamine, une résine de phtalate de diallyle, une résine de polyimide, une résine de bis-maléimide-triazine, une composition de résine comprenant du polyoxyphénylène et un polymère réticulable ou un monomère réticulable, et une composition de résine comprenant du poly(sulfure de phénylène) et un polymère réticulable ou un monomère réticulable.

4. Carte pour circuits haute fréquence selon la revendication 3, dans laquelle la résine durcissable est choisie parmi l'ensemble comprenant une résine de polyester insaturée, une résine époxyde et une résine de polyimide.

5. Carte pour circuits haute fréquence selon la revendication 1, dans laquelle le matériau de renforcement est choisi parmi l'ensemble comprenant un tissu de verre, un tissu non-tissé de verre, un tissu non-tissé constitué de fibres plastiques, un tissu tissé constitué de fibres plastiques et leurs mélanges, et la résine durcissable durcie contenue dans la couche de renforcement est un produit durci constitué d'une résine durcissable choisie parmi l'ensemble comprenant une résine de polyester, une résine époxyde, une résine phénolique, une résine de mélamine, une résine de phtalate de diallyle, une résine de polyimide, une résine de bis-maléimidetriazine, une composition de résine comprenant du polyoxyphénylène (PPO) et un polymère réticulable ou un monomère réticulable, et une composition de résine comprenant du poly(sulfure de phénylène) (PPS) et un polymère réticulable ou un monomère réticulable.

6. Carte pour circuits haute fréquence selon la revendication 5, dans laquelle la résine durcissable est choisie parmi l'ensemble comprenant une résine de polyester insaturé, une résine époxyde et une résine de polyimide.

7. Carte pour circuits haute fréquence selon la revendication 1, dans laquelle le conducteur métallique est une couche d'un métal choisi parmi l'ensemble comprenant le cuivre, le cupro-nickel, le bronze, le laiton, l'aluminium, le nickel, le fer, l'acier inoxydable, l'or, l'argent et le platine.

8. Carte pour circuits haute fréquence selon la revendication 1, dans laquelle le matériau de renforcement est choisi parmi l'ensemble comprenant un tissu de verre, un tissu non-tissé de verre, un tissu non-tissé de fibres plastiques, un tissu tissé de fibres plastiques et leurs mélanges, la couche conductrice métallique est une couche d'un métal choisi parmi l'ensemble comprenant le cuivre, le cupro-nickel, le bronze, le laiton, l'aluminium, le nickel, le fer, l'acier inoxydable, l'or, l'argent et le platine, et la résine durcissable durcie contenue dans la feuille de résine est la même résine que la résine durcissable durcie contenue dans la couche de renforcement, et est un produit durci constitué d'une résine durcissable choisie parmi l'ensemble comprenant une résine de polyester, une résine époxyde, une résine phénolique, une résine de mélamine, une résine de phtalate de diallyle, une résine de polyimide, une résine de bis-maléimide-triazine, une composition de résine comprenant du polyoxyphénylène (PPO) et un polymère réticulable ou un monomère réticulable, et une composition de résine comprenant du poly(sulfure de phénylène) (PPS) et un polymère réticulable ou un monomère réticulable.

9. Carte pour circuits haute fréquence selon la revendication 8, dans laquelle la résine durcissable est choisie parmi l'ensemble comprenant une résine de polyester insaturé, une résine époxyde et une résine de polyimide.

10. Carte pour circuits haute fréquence selon la revendication 9, dans laquelle le composé organique halogéné est dispersé dans la feuille de résine.

11. Carte pour circuits haute fréquence selon la revendication 10, dans laquelle la résine durcissable est une résine époxyde, le matériau de renforcement est un tissu de verre, la couche conductrice métallique est une couche de cuivre et le composé organique halogéné est le 1,2,3,4,7,8,9,10,13,13,14,14-dodécachloro-1,4,4a,5,6,6a,7,10,10a,11,12,12a-dodécahydro-1,4:7,10-diméthanodibenzo(a,e)cyclooctène.
